# EUROPEAN PATENT APPLICATION

(11) **EP 4 648 110 A1**
(43) Date of publication of application: **12.11.2025**
(21) Application number: 23923756.3
(22) Date of filing: 13.11.2023
(51) Int. Cl.: H01L 29/06

(54) **GALLIUM NITRIDE SEMICONDUCTOR DEVICE AND PREPARATION METHOD THEREFOR**

(30) Priority: 21.02.2023 CN 202310153162
(71) Applicant: Southeast University, Nanjing City, Jiangsu 210096 (CN); CSMC Technologies Fab2 Co., Ltd., Wuxi, Jiangsu 214028 (CN)
(72) Inventor: ZHANG, Long, Wuxi, Jiangsu 214028 (CN); HE, Nailong, Wuxi, Jiangsu 214028 (CN); SUN, Yuan, Wuxi, Jiangsu 214028 (CN); ZHANG, Sen, Wuxi, Jiangsu 214028 (CN); MA, Jie, Wuxi, Jiangsu 214028 (CN); ZHANG, Zhili, Wuxi, Jiangsu 214028 (CN); LIU, Siyang, Wuxi, Jiangsu 214028 (CN); SUN, Weifeng, Wuxi, Jiangsu 214028 (CN)
(74) Representative: Manitz Finsterwald Patent- und Rechtsanwaltspartnerschaft mbB
(86) International application number: PCT/CN2023/131232
(87) International publication number: WO 2024/174592

(57) **Abstract**

The present application relates to a gallium nitride semiconductor device and a preparation method therefor. The gallium nitride semiconductor device (1) comprises: a substrate (10); a first gallium nitride layer (21), which is arranged on the substrate; a first dielectric layer (22), which is arranged on the first gallium nitride layer (21); and a first gate electrode (23), which is arranged on the first dielectric layer (22). According to the gallium nitride semiconductor device and the preparation method therefor provided in the present application, a first dielectric layer (22) is provided between a first gate electrode (23) and a first gallium nitride layer (21). In this way, a high-concentration two-dimensional electron gas, which is generated by means of the first dielectric layer and the first gallium nitride layer due to a polarization effect, can consume a hole in a region where the first gate electrode is located, so as to improve a threshold voltage of the device; and compared with a gallium nitride semiconductor device which is not provided with a first dielectric layer, insofar as it is ensured that a device is in an enhancement mode, the present application can make the thickness of the first gallium nitride layer below the first gate electrode greater, so as to reduce the on-resistance of the device, thereby improving an output current of the device.

## Description

### CROSS-REFERENCE TO RELATED APPLICATION

This application claims priority to Chinese Patent Application No. 202310153162.8, filed with CNIPA on February 21, 2023, titled as "GALLIUM NITRIDE SEMICONDUCTOR DEVICE AND METHOD FOR MANUFACTURING THE SAME", the entire contents of which are incorporated herein by reference.

### TECHNICAL FIELD

This application relates to the technical field of integrated circuits, and in particular, to a gallium nitride semiconductor device and a method for manufacturing the same.

### BACKGROUND

Gallium nitride is a key semiconductor material having wide band gap. For a main application scenario of the gallium nitride material, high concentration of two-dimensional electron gas, 2DEG, is generated at an interface of an AlGaN/GaN heterojunction structure. Gallium nitride circuits with excellent performance can be designed based on the 2DEG due to its good high-frequency characteristics. Currently, both the output current and the threshold voltage of a P-channel gallium nitride device are relatively low, so it is not easy to apply the P-channel gallium nitride device to a gallium nitride integrated circuit.

### SUMMARY

In view of the above, it is necessary to provide a gallium nitride semiconductor device and a method for manufacturing the same to solve at least one of the above problems.

To fulfill at least one of the mentioned objectives, in a first aspect, the present application provides a gallium nitride semiconductor device, including:
a substrate;
a first gallium nitride layer disposed on the substrate;
a first dielectric layer disposed on the first gallium nitride layer; and
a first gate disposed on the first dielectric layer.

In an embodiment, the gallium nitride semiconductor device further includes a second gallium nitride layer disposed on the first dielectric layer. The second gallium nitride layer is provided with a groove penetrating through the second gallium nitride layer, and at least a part of the first gate is located in the groove.

In an embodiment, the first gate includes:
a first gate dielectric layer, covering at least a bottom of the groove and sidewalls of the groove; and
a first gate electrode layer disposed on the first gate dielectric layer.

In an embodiment, the gallium nitride semiconductor device further includes:
a third gallium nitride layer, which is disposed on the first gallium nitride layer and is at least located at two sides of the first dielectric layer; and
a first source and a first drain, which are respectively disposed on the third gallium nitride layer at two sides of the first dielectric layer.

In an embodiment, a doping concentration of the second gallium nitride layer is greater than a doping concentration of the first gallium nitride layer.

In an embodiment, a doping concentration of the third gallium nitride layer is greater than a doping concentration of the second gallium nitride layer, and the doping concentration of the third gallium nitride layer is greater than a doping concentration of the first gallium nitride layer.

In an embodiment, a material of the first dielectric layer includes aluminum nitride; and/or a thickness of the first dielectric layer ranges from 1nm to 2nm; and/or a thickness of the first gallium nitride layer ranges from 10nm to 30nm.

In an embodiment, the gallium nitride semiconductor device further includes:
an isolation layer, which is disposed in the substrate and divides the substrate into a first portion and a second portion, the first gallium nitride layer being located on the first portion of the substrate;
a fourth gallium nitride layer, disposed on the second portion of the substrate;
a second dielectric layer, disposed on the fourth gallium nitride layer;
a fifth gallium nitride layer, disposed on the second dielectric layer;
a second gate, disposed on the fifth gallium nitride layer; and
a second source and a second drain, which are disposed on the second portion of the substrate and are respectively located at two sides of the fourth gallium nitride layer.

In an embodiment, the substrate includes a semiconductor layer, a nucleation layer, a buffer layer, a channel layer, and a barrier layer stacked in sequence. The isolation layer is disposed in the buffer layer, the channel layer, and the barrier layer.

In a second aspect, the present application provides a method for manufacturing a gallium nitride semiconductor device, including:
obtaining a substrate;
forming a first gallium nitride layer on the substrate;
forming a first dielectric layer on the first gallium nitride layer; and
forming a first gate on the first dielectric layer.

In an embodiment, the step of forming the first dielectric layer on the first gallium nitride layer includes: sequentially forming the first dielectric layer and a second gallium nitride layer on the first gallium nitride layer. The first dielectric layer is located between the first gallium nitride layer and the second gallium nitride layer.

In an embodiment, after the step of forming the first dielectric layer on the first gallium nitride layer and before the step of forming the first gate on the first dielectric layer, the method further includes: forming a third gallium nitride layer on the first gallium nitride layer. The third gallium nitride layer is located at two sides of the first dielectric layer.

In an embodiment, the step of forming the first gate on the first dielectric layer includes:
forming a groove in the second gallium nitride layer, the groove penetrating through the second gallium nitride layer;
forming a first gate dielectric layer in the groove, the first gate dielectric layer covering at least a bottom of the groove and sidewalls of the groove; and
forming a first gate electrode layer on the first gate dielectric layer.

In an embodiment, the step of forming the first gallium nitride layer on the substrate includes:
forming the first gallium nitride layer on a first portion of the substrate; and
forming a fourth gallium nitride layer, a second dielectric layer and a fifth gallium nitride layer stacked on a second portion of the substrate.

In an embodiment, after the step of forming the third gallium nitride layer on the first gallium nitride layer and before the step of forming the first gate on the first dielectric layer, the method further includes: forming a first source, a first drain, a second source and a second drain on the substrate. The first source and the first drain are respectively located on the third gallium nitride layer at two sides of the first dielectric layer. The second source and the second drain are respectively located on the second portion at two sides of the fourth gallium nitride layer.

In the gallium nitride semiconductor device and the method for manufacturing the same, the first dielectric layer is disposed between the first gate and the first gallium nitride layer. With this arrangement, for one thing, a two-dimensional electron gas with a high concentration generated due to the polarization effect between the first dielectric layer and the first gallium nitride layer can consume holes in a region in which the first gate is located, thereby increasing a threshold voltage of the device; for another, compared with the gallium nitride semiconductor device without the first dielectric layer, on the premise of ensuring the enhancement mode of the device, the present application can increase a thickness of the first gallium nitride layer under the first gate, thereby reducing an on-resistance of the device and increasing an output current of the device.

### BRIEF DESCRIPTION OF THE DRAWINGS

To describe the technical solutions in the embodiments or the examples of the present application more clearly, the following briefly describes the accompanying drawings required for describing the embodiments or the examples. Apparently, the accompanying drawings in the following description are merely for some embodiments of the present application, and a person of ordinary skill in the art may still derive other accompanying drawings from these accompanying drawings without creative efforts.
FIG. 1 is a schematic structural diagram of a gallium nitride semiconductor device according to an embodiment of the present disclosure;
FIG. 2 is a schematic flowchart of a method for manufacturing a gallium nitride semiconductor device according to an embodiment of the present disclosure;
FIG. 3 is a schematic flowchart of step S400 in the manufacturing method shown in FIG. 2; and
FIGS. 4 to 11 are schematic cross-sectional structural diagrams of a device when manufacturing a gallium nitride semiconductor device by using the manufacturing method shown in FIG. 2.

Description of numeric references is as follows:
1: gallium nitride semiconductor device; 10: substrate; 10a: first portion; 10b: second portion; 11: semiconductor layer; 12: nucleation layer; 13: buffer layer; 14: channel layer; 15: barrier layer; 20: P-channel device; 21: first gallium nitride layer; 22: first dielectric layer; 23: first gate; 231: first gate dielectric layer; 232: first gate electrode layer; 24: second gallium nitride layer; 241: groove; 25: third gallium nitride layer; 26: first source; 27: first drain; 30: isolation layer; 40: N-channel device; 41: fourth gallium nitride layer; 42: second dielectric layer; 43: fifth gallium nitride layer; 44: second gate; 45: second source; 46: second drain; 51: first gallium nitride material layer; 52: first dielectric material layer; 53: second gallium nitride material layer.

### DETAILED DESCRIPTION

To facilitate understanding of the present application, the present application is described more fully hereinafter with reference to the accompanying drawings. The accompanying drawings show embodiments of the present application. However, the present application may be implemented in many different forms and is not limited to the embodiments described herein. Rather, these embodiments are provided so that the present disclosure becomes thorough and complete.

Unless defined otherwise, all technical and scientific terms used herein have the same meaning as commonly understood by one of ordinary skill in the art to which the present application pertains. The terms used in the specification of the present application are only for the purpose of describing specific embodiments, and are not intended to limit the present application.

It shall be understood that when an element or layer is referred to as being "on", "adjacent to", "connected to" or "coupled to" another element or layer, the referred element or layer can be arranged directly on the other element or layer, directly adjacent to the other element or layer, directly connected to or directly coupled to the other element or layer; or, an intervening element or layer may be present therebetween. In contrast, when an element is referred to as being "directly on," "directly adjacent to," "directly connected to," or "directly coupled to" another element or layer, there are no intervening elements or layers present. It shall be understood that, although the terms first, second, third, etc. may be used herein to describe various elements, components, regions, layers, doping types and/or parts, these elements, components, regions, layers, doping types and/or parts should not be limited by these terms. These terms are only used to distinguish one element, component, region, layer, doping type or part from another element, component, region, layer, doping type or part. Thus, a first element, component, region, layer, doping type, or part discussed below can be termed a second element, component, region, layer, or part without departing from the teachings of the present disclosure. For example, a first doping type can be termed a second doping type, and similarly, a second doping type can be termed a first doping type. The first doping type differs from the second doping type, such as, the first doping type may be P-type and the second doping type may be N-type, or the first doping type may be N-type and the second doping type may be P-type.

Spatially relative terms, such as "under", "below", "lower", "beneath", "above", "upper", may be used herein for ease of description to describe one element or feature's relationship to another element or feature as illustrated in the drawings. It can be understood that the spatially relative terms may encompass different orientations of the device in use or operation in addition to the orientation depicted in the drawings. For example, if the device in the drawings is turned over, elements or features described as "below" or "under" other elements or features would then be oriented "above" the other elements or features. Thus, the exemplary terms "below" and "under" can encompass both orientations of above and below. In addition, the device may also have additional orientations (for example, rotated by 90 degrees or other orientations), and the spatial description used herein is interpreted accordingly.

As used herein, the singular forms "a", "an" and "the" may be intended to include the plural forms as well, unless the context clearly indicates otherwise. It can be further understood that the terms "comprise/include", "contain", etc. specify the presence of stated feature(s), integer(s), step(s), operation(s), element(s), part(s), or any combination thereof, but do not preclude the presence or addition of one or more other features, integers, steps, operations, elements, parts, or combinations thereof. Also, in the specification, the term "and/or" includes any and all combinations of listed items associated by such term.

Embodiments of the present application are described herein with reference to cross-sectional illustrations that are schematic illustrations of idealized embodiments (and intermediate structures) of the present application, such that variations from the shapes of the illustrations as a result, for example, of manufacturing techniques and/or tolerances can be expected. Thus, embodiments of the present application should not be limited to the particular shapes of the regions illustrated herein, but are to include deviations in shapes that result, for example, from manufacturing techniques. For example, an implanted region shown as a rectangle typically has rounded or curved features and/or a gradient of implant concentration at its edges rather than a binary change from implanted to non-implanted regions. Likewise, a buried region formed by implantation may result in some implantation into a region between the buried region and a surface through which the implantation passes. Thus, the regions illustrated in the drawings are schematic in nature, and their shapes do not represent actual shapes of regions of the device and do not limit the scope of the present application.

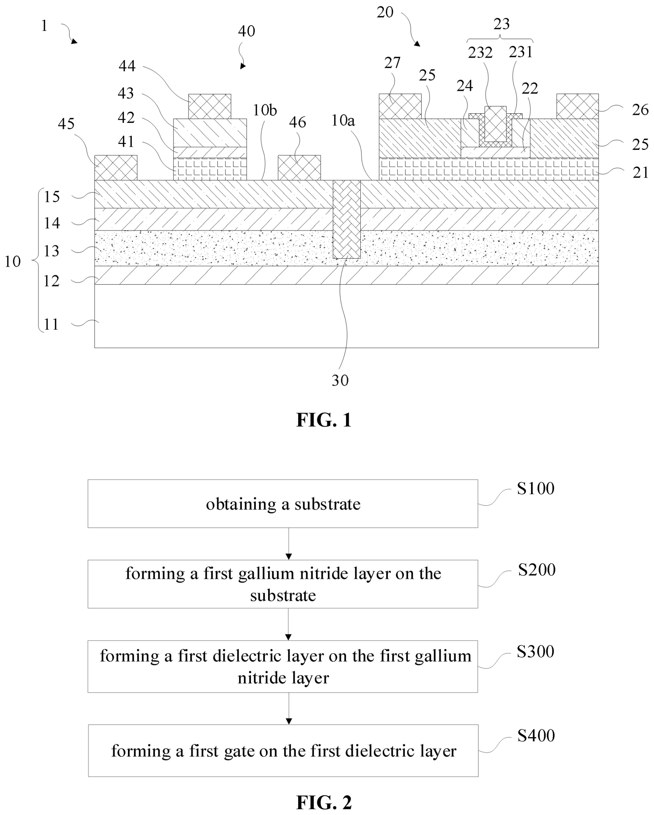

In a first aspect, referring to FIG. 1, a gallium nitride semiconductor device 1 is provided according to an embodiment of the present application. The gallium nitride semiconductor device 1 may include a P-channel device 20 and an N-channel device 40. That is, the gallium nitride semiconductor device 1 is an integrated structure jointly formed by the P-channel device 20 and the N-channel device 40. Alternatively, the gallium nitride semiconductor device 1 may include only the P-channel device 20. In the embodiment of the present application, it is exemplarily illustrated based on the integrated structure formed by the P-channel device 20 and the N-channel device 40 together.

The gallium nitride semiconductor device 1 includes: a substrate 10, a first gallium nitride layer 21, a first dielectric layer 22, and a first gate 23. The first gallium nitride layer 21 is disposed on the substrate 10. The first dielectric layer 22 is disposed on the first gallium nitride layer 21. The first gate electrode 23 is disposed on the first dielectric layer 22. It can be understood that the first gallium nitride layer 21, the first dielectric layer 22, and the first gate 23 are at least a part of the structure of the P-channel device 20.

In an example, the first gallium nitride layer 21 may be a P-type doped gallium nitride layer.

In the gallium nitride semiconductor device 1 provided in the embodiment of the present application, the first dielectric layer 22 is disposed between the first gate 23 and the first gallium nitride layer 21. With this arrangement, for one thing, a two-dimensional electron gas with a high concentration generated due to the polarization effect between the first dielectric layer 22 and the first gallium nitride layer 21 can consume holes in a region in which the first gate 23 is located, thereby increasing a threshold voltage of the device; for another, compared with the gallium nitride semiconductor device 1 without the first dielectric layer 22, on the premise of ensuring the enhancement mode of the device, the structure in the present application can increase a thickness of the first gallium nitride layer 21 under the first gate 23, thereby reducing an on-resistance of the device and increasing an output current of the device.

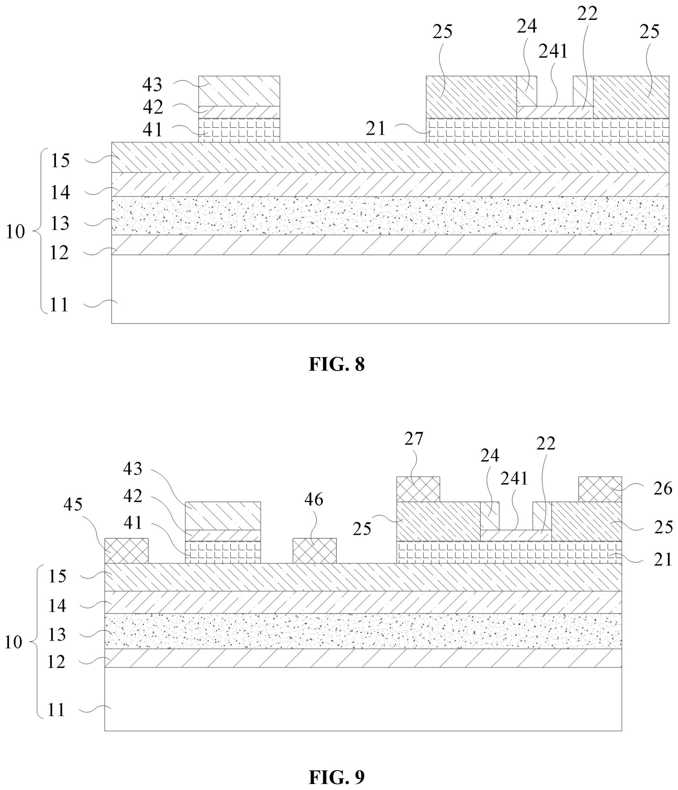

In an embodiment, referring to FIGS. 1 and 8, the P-channel device 20 of the gallium nitride semiconductor device 1 further includes a second gallium nitride layer 24 disposed on the first dielectric layer 22. The second gallium nitride layer 24 is provided with a groove 241 penetrating through the second gallium nitride layer 24, and at least a part of the first gate 23 is located in the groove 241. In this way, the enhancement mode P-channel device 20 can be formed. Compared with the gallium nitride semiconductor device 1 without the first dielectric layer 22, the thickness of the first gallium nitride layer 21 under the first gate 23 can be increased, thereby reducing the on-resistance of the device and increasing the output current of the device.

In an example, the second gallium nitride layer 24 may be a P-type doped gallium nitride layer.

In an example, a doping concentration of the second gallium nitride layer 24 is greater than a doping concentration of the first gallium nitride layer 21.

In an embodiment, the first gate 23 includes a first gate dielectric layer 231 and a first gate electrode layer 232. The first gate dielectric layer 231 covers at least a bottom of the groove 241 and sidewalls of the groove 241. The first gate electrode layer 232 is disposed on the first gate dielectric layer 231.

In an example, the first gate dielectric layer 231 further covers at least a part of a surface of the second gallium nitride layer 24, and the first gate electrode layer 232 fills up the groove 241.

In an example, the first gate dielectric layer 231 may be made from a material with a large forbidden band width such as aluminum oxide, silicon oxide, or silicon nitride. For one thing, such materials can further reduce a valence band height at the heterojunction and increase the threshold voltage of the device; for another, since a higher voltage can be withstood due to the large forbidden band width, the withstand voltage of the first gate 23 can be enhanced.

In an example, a material of the first gate electrode layer 232 may include a metal or an alloy.

In an embodiment, the P-channel device 20 of the gallium nitride semiconductor device 1 may further include: a first source 26, a first drain 27, and a third gallium nitride layer 25. The third gallium nitride layer 25 is disposed on the first gallium nitride layer 21, and is located at least at two sides of the first dielectric layer 22. The first source 26 and the first drain 27 are respectively disposed on the third gallium nitride layer 25 at two sides of the first dielectric layer 22. In this way, the first gate 23 serves as a gate of the P-channel device 20, the first source 26 serves as a source of the P-channel device 20, and the first drain 27 serves as a drain of the P-channel device 20.

In an example, a material of each of the first source 26 and the first drain 27 may include a metal or an alloy.

In an embodiment, the third gallium nitride layer 25 may be a P-type doped gallium nitride layer. In an example, a doping concentration of the third gallium nitride layer 25 is greater than the doping concentration of the second gallium nitride layer 24, and the doping concentration of the third gallium nitride layer 25 is greater than the doping concentration of the first gallium nitride layer 21. In this way, ohmic contact resistances of the first source 26 and the first drain 27 can be reduced.

In an embodiment, a material of the first dielectric layer 22 includes aluminum nitride. By setting the material of the first dielectric layer 22 to be aluminum nitride, it is beneficial for the polarization effect to generate a two-dimensional electron gas with a high concentration, thereby consuming holes in the region where the first gate 23 is located, and as a result, increasing the threshold voltage of the device.

In an embodiment, a thickness of the first dielectric layer 22 ranges from 1nm to 2nm. Here, the thickness of the first dielectric layer 22 refers to a distance between an upper surface of the first dielectric layer 22 and a lower surface of the first dielectric layer 22. Exemplarily, the thickness of the first dielectric layer 22 may be 1nm, 1.5nm, 1.8nm or 2nm. By setting the thickness of the first dielectric layer 22 to be within the aforementioned range, it is beneficial for the polarization effect to generate the two-dimensional electron gas with the high concentration, thereby consuming holes in the region where the first gate 23 is located, and as a result, increasing the threshold voltage of the device.

In an embodiment, a thickness of the first gallium nitride layer 21 ranges from 10nm to 30nm. Here, the thickness of the first gallium nitride layer 21 refers to a distance between an upper surface of the first gallium nitride layer 21 and a lower surface of the first gallium nitride layer 21. For example, the thickness of the first gallium nitride layer 21 may be 10nm, 15nm, 20nm, 26nm, or 30nm. With this arrangement, the thickness of the first gallium nitride layer 21 can be increased when compared with the gallium nitride semiconductor device 1 without the first dielectric layer 22, thereby reducing the on-resistance of the device and increasing the output current of the device.

It should be noted that the values and numerical ranges involved in the embodiments of the present application are approximate, and due to the influence of the manufacturing process, there may be a certain range of errors, which may be considered to be negligible by those skilled in the art.

In an embodiment, the gallium nitride semiconductor device 1 further includes an isolation layer 30. The isolation layer 30 is disposed in the substrate 10 and divides the substrate 10 into a first portion 10a and a second portion 10b. The first gallium nitride layer 21 is located on the first portion 10a of the substrate 10. It is understood that the P-channel device 20 is located on the first portion 10a of the substrate 10.

The gallium nitride semiconductor device 1 further includes an N-channel device 40. The N-channel device 40 includes: a fourth gallium nitride layer 41, a second dielectric layer 42, a fifth gallium nitride layer 43, a second gate 44, a second source 45 and a second drain 46. The fourth gallium nitride layer 41 is disposed on the second portion 10b of the substrate 10. The second dielectric layer 42 is disposed on the fourth gallium nitride layer 41. The fifth gallium nitride layer 43 is disposed on the second dielectric layer 42. The second gate 44 is disposed on the fifth gallium nitride layer 43. The second source 45 and the second drain 46 are disposed on the second portion 10b of the substrate 10 and are respectively located at two sides of the fourth gallium nitride layer 41. It can be understood that the second gate 44 serves as a gate of the N-channel device 40, the second source 45 serves as a source of the N-channel device 40, and the second drain 46 serves as a drain of the N-channel device 40.

In an example, the fourth gallium nitride layer 41 and the fifth gallium nitride layer 43 may be P-type doped gallium nitride layers.

In an example, a doping concentration of the fifth gallium nitride layer 43 is greater than a doping concentration of the fourth gallium nitride layer 41.

In an embodiment, the substrate 10 includes a semiconductor layer 11, a nucleation layer 12, a buffer layer 13, a channel layer 14, and a barrier layer 15 that are sequentially stacked. The isolation layer 30 is disposed in the buffer layer 13, the channel layer 14, and the barrier layer 15.

In an example, a material of the semiconductor layer 11 may include monocrystalline silicon, polycrystalline silicon, amorphous silicon, a silicon-germanium compound, low temperature Poly-Silicon, LTPS, or the like, or other materials known to those skilled in the art.

In an example, a material of the nucleation layer 12 may include aluminum nitride; a material of the buffer layer 13 may include aluminum gallium nitride, aluminum nitride, or gallium nitride; a material of the channel layer 14 may include gallium nitride; and a material of the barrier layer 15 may include aluminum gallium nitride.

In an example, a material of each of the second gate 44, the second source 45 and the second drain 46 may include a metal or an alloy.

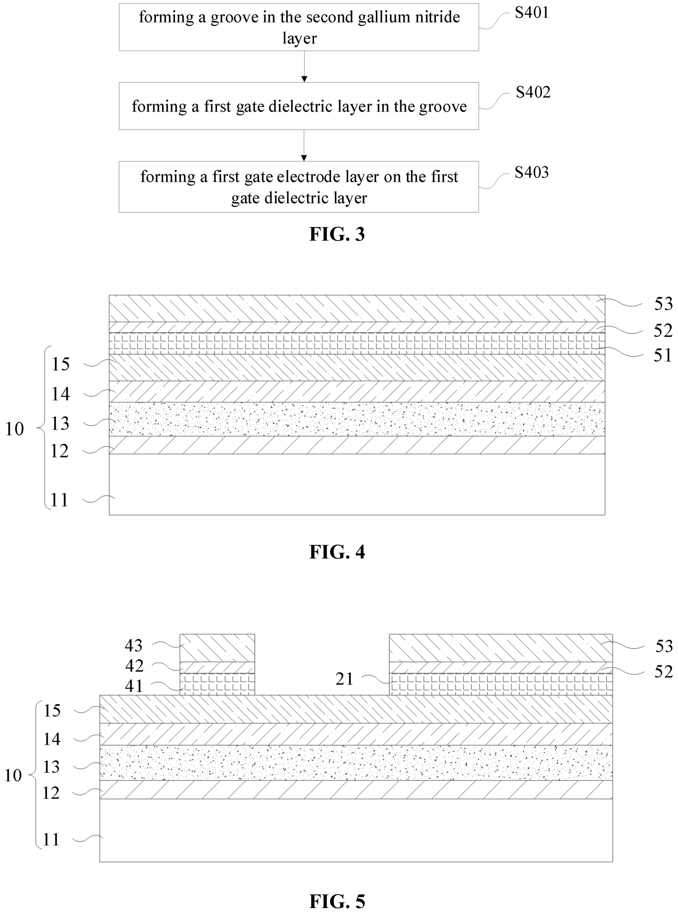

As shown in FIG. 2 and with reference to FIG. 4 to FIG. 11, a method for manufacturing a gallium nitride semiconductor device 1 is provided according to an embodiment of the present application. The method includes the following steps.

S100 includes: obtaining a substrate 10.

S200 includes: forming a first gallium nitride layer 21 on the substrate 10. In an example, the first gallium nitride layer 21 may be a P-type doped gallium nitride layer.

S300 includes: forming a first dielectric layer 22 on the first gallium nitride layer 21. In an example, a material of the first dielectric layer 22 may include aluminum nitride. In an example, a thickness of the first dielectric layer 22 is in a range from 1nm to 2nm.

S400 includes: forming a first gate 23 on the first dielectric layer 22.

In the above method for manufacturing the gallium nitride semiconductor device 1, the first dielectric layer 22 is formed between the first gate 23 and the first gallium nitride layer 21. With this arrangement, for one thing, a two-dimensional electron gas with a high concentration generated due to the polarization effect between the first dielectric layer 22 and the first gallium nitride layer 21 can consume holes in a region in which the first gate 23 is located, thereby increasing a threshold voltage of the device; for another, compared with the gallium nitride semiconductor device 1 without the first dielectric layer 22, on the premise of ensuring the enhancement mode of the device, the method in the present application can increase a thickness of the first gallium nitride layer 21 under the first gate 23, thereby reducing an on-resistance of the device and increasing an output current of the device.

In an embodiment, step S100 of obtaining the substrate 10 may further include S101 and S102.

S101 includes: providing a semiconductor layer 11. In an example, a material of the semiconductor layer 11 may include monocrystalline silicon, polycrystalline silicon, amorphous silicon, a silicon-germanium compound, low temperature Poly-Silicon, LTPS, or the like.

S102 includes: sequentially forming a nucleation layer 12, a buffer layer 13, a channel layer 14, and a barrier layer 15 on the semiconductor layer 11. The substrate 10 can be formed by the semiconductor layer 11, the nucleation layer 12, the buffer layer 13, the channel layer 14, and the barrier layer 15. In an example, the nucleation layer 12, the buffer layer 13, the channel layer 14, and the barrier layer 15 may be formed on the semiconductor layer 11 through an epitaxial growth process.

In an embodiment, after step S100 of obtaining the substrate 10 and before step S200 of forming the first gallium nitride layer 21 on the substrate 10, the method may further include:
S150: sequentially forming a first gallium nitride material layer 51, a first dielectric material layer 52, and a second gallium nitride material layer 53 on the substrate 10.

A structure formed by the first gallium nitride material layer 51, the first dielectric material layer 52, and the second gallium nitride material layer 53 is shown in FIG. 4.

In an embodiment, step S200 of forming the first gallium nitride layer 21 on the substrate 10 may further include:
S201: forming the first gallium nitride layer 21 on a first portion 10a of the substrate 10; and
S202: forming a fourth gallium nitride layer 41, a second dielectric layer 42 and a fifth gallium nitride layer 43 stacked on a second portion 10b of the substrate 10.

It should be noted that, referring to FIG. 5, steps S201 and S202 may be completed in a same process. That is, the first gallium nitride material layer 51, the first dielectric material layer 52 and the second gallium nitride material layer 53 are etched to form the first gallium nitride layer 21, the fourth gallium nitride layer 41, the second dielectric layer 42 and the fifth gallium nitride layer 43. The first gallium nitride layer 21 is located on the first portion 10a of the substrate 10. The fourth gallium nitride layer 41, the second dielectric layer 42, and the fifth gallium nitride layer 43 are sequentially stacked on the second portion 10b of the substrate 10.

In an embodiment, step S300 of forming the first dielectric layer 22 on the first gallium nitride layer 21 may further include:
S301: sequentially forming the first dielectric layer 22 and a second gallium nitride layer 24 on the first gallium nitride layer 21, where the first dielectric layer 22 is located between the first gallium nitride layer 21 and the second gallium nitride layer 24.

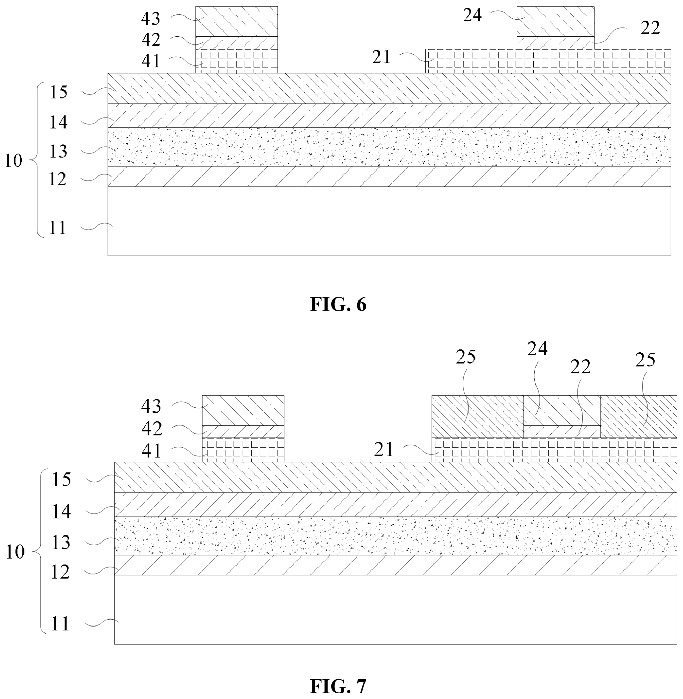

It can be understood that, referring to FIG. 6, in step S301, the first dielectric material layer 52 and the second gallium nitride material layer 53 on the first gallium nitride material layer 51 may be synchronously etched to form the first dielectric layer 22 and the second gallium nitride layer 24 on the first gallium nitride layer 21.

In an embodiment, after step S300 of forming the first dielectric layer 22 on the first gallium nitride layer 21 and before step S400 of forming the first gate 23 on the first dielectric layer 22, the method may further include:
S350: forming a third gallium nitride layer 25 on the first gallium nitride layer 21.

The third gallium nitride layer 25 is located at two sides of the first dielectric layer 22. A structure after formation of the third gallium nitride layer 25 is shown in FIG. 7.

In an example, the third gallium nitride layer 25 may be a P-type doped gallium nitride layer. A doping concentration of the third gallium nitride layer 25 is greater than a doping concentration of the first gallium nitride layer 21 and a doping concentration of the second gallium nitride layer 24. In this way, ohmic contact resistances of a first source 26 and a first drain 27 can be reduced.

In an embodiment, referring to FIG. 3, step S400 of forming the first gate 23 on the first dielectric layer 22 may further include S401 to S403.

S401 includes: forming a groove 241 in the second gallium nitride layer 24. The groove 241 penetrates through the second gallium nitride layer 24.

Specifically, the groove 241 penetrates through the second gallium nitride layer 24 means that, at least a part of the first dielectric layer 22 is exposed through a bottom of the groove 241. In an example, referring to FIG. 8, the second gallium nitride layer 24 may be etched and the first dielectric layer 22 serves as an etch stop layer, so that the groove 241 is formed in the second gallium nitride layer 24, to implement the enhancement mode of the P-channel device 20.

S402 includes: forming a first gate dielectric layer 231 in the groove 241. The first gate dielectric layer 231 covers at least the bottom of the groove 241 and sidewalls of the groove 241.

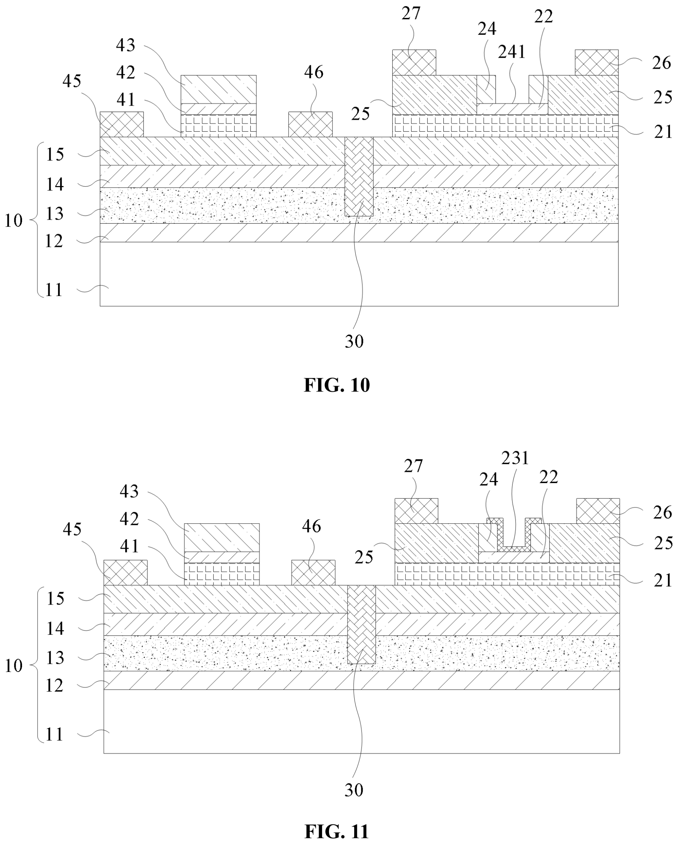

In an example, the first gate dielectric layer 231 may be made from a material with a large forbidden band width such as aluminum oxide, silicon oxide, or silicon nitride. A structure after formation of the first gate dielectric layer 231 is shown in FIG. 11.

S403 includes: forming a first gate electrode layer 232 on the first gate dielectric layer 231.

In an example, a material of the first gate electrode layer 232 may include a metal or an alloy, and the first gate electrode layer 232 may be formed by a metal sputtering process. A structure after formation of the first gate electrode layer 232 is shown in FIG. 1. It can be understood that in step S403, a second gate 44 may also be formed synchronously.

In an embodiment, after step S350 of forming the third gallium nitride layer 25 on the first gallium nitride layer 21 and before step S400 of forming the first gate 23 on the first dielectric layer 22, the method may further include:
S360: forming a first source 26, a first drain 27, a second source 45 and a second drain 46 on the substrate 10.

Specifically, referring to FIG. 9, the first source 26 and the first drain 27 are respectively located on the third gallium nitride layer 25 at two sides of the first dielectric layer 22, and the second source 45 and the second drain 46 are respectively located on the second portion 10b at two sides of the fourth gallium nitride layer 41. In an example, a material of each of the first source 26, the first drain 27, the second source 45 and the second drain 46 may include a metal or an alloy. The first source 26, the first drain 27, the second source 45, and the second drain 46 may be formed by a metal sputtering process.

In an embodiment, after step S360 of forming the first source 26, the first drain 27, the second source 45, and the second drain 46 on the substrate 10 and before step S400 of forming the first gate 23 on the first dielectric layer 22, the method may further include:
S370: forming an isolation layer 30 on the substrate 10.

Specifically, referring to FIG. 1 and FIG. 10, the isolation layer 30 is located between the P-channel device 20 and the N-channel device 40, the isolation layer 30 divides the substrate 10 into the first portion 10a and the second portion 10b, the P-channel device 20 is located on the first portion 10a, and the N-channel device 40 is located on the second portion 10b.

In an example, the isolation layer 30 may be formed by implanting high energy particles into the barrier layer 15, the channel layer 14 and the buffer layer 13 by an ion implantation technique.

It can be understood that after the ion implantation, the substrate 10 may be annealed. The annealing treatment can repair the lattice loss to the substrate 10 during the ion implantation process and activate dopant ions. Specifically, the substrate 10 after the ion implantation may be annealed by using a rapid thermal annealing, RTA, process. The RTA process needs shorter time for annealing than an ordinary annealing process, which may avoid the diffusion of the dopant ions caused by long time of high temperature and reduce the instantaneous enhanced diffusion of the dopant ions.

It should be understood that although the steps in the flowchart of the present application are sequentially displayed as indicated by the arrows, these steps are not necessarily performed in the order indicated by the arrows. Unless explicitly stated herein, the execution of these steps is not strictly limited, and these steps may be executed in other orders. Moreover, at least a part of the steps in the flowchart of the present application may include multiple sub-steps or multiple stages, these sub-steps or stages are not necessarily performed at the same time, but may be performed at different times, and the execution order of these sub-steps or stages is not necessarily performed sequentially, but may be performed in turn or alternately with at least a part of other steps or sub-steps or stages in other steps.

In the specification, descriptions of "some embodiments", "other embodiments", "an ideal embodiment", or the like means that a particular feature, structure, material, or characteristic described in connection with the embodiment or example is included in at least one embodiment or example of the present application. In this specification, the schematic description of the above terms does not necessarily refer to the same embodiment or example.

The technical features of the embodiments described above may be combined arbitrarily, and in order to make the description concise, not all possible combinations of the technical features of the embodiments described above are described; however, as long as no contradiction can be caused by the combinations of these technical features, it should be considered as the scope of the present specification.

The above embodiments only express several implementations of the present application, and the description thereof is specific and detailed, but cannot be understood as a limitation to the patent scope. It should be noted that for those of ordinary skill in the art, several variations and improvements can be made without departing from the concept of the present application, which all fall within the protection scope of the present application. Therefore, the protection scope of the present application should be subject to the appended claims.

## Claims

1. A gallium nitride semiconductor device, **characterized by** comprising:
a substrate;
a first gallium nitride layer, which is disposed on the substrate;
a first dielectric layer, which is disposed on the first gallium nitride layer; and
a first gate, which is disposed on the first dielectric layer.

2. The gallium nitride semiconductor device according to claim 1, further comprising a second gallium nitride layer which is disposed on the first dielectric layer;
wherein the second gallium nitride layer is provided with a groove penetrating through the second gallium nitride layer, and at least a part of the first gate is located in the groove.

3. The gallium nitride semiconductor device according to claim 2, wherein the first gate comprises:
a first gate dielectric layer, which covers at least a bottom of the groove and sidewalls of the groove; and
a first gate electrode layer, which is disposed on the first gate dielectric layer.

4. The gallium nitride semiconductor device according to claim 2, further comprising:
a third gallium nitride layer, which is disposed on the first gallium nitride layer and is at least located at two sides of the first dielectric layer; and
a first source and a first drain, which are respectively disposed on the third gallium nitride layer at two sides of the first dielectric layer.

5. The gallium nitride semiconductor device according to claim 4, wherein a doping concentration of the second gallium nitride layer is greater than a doping concentration of the first gallium nitride layer.

6. The gallium nitride semiconductor device according to claim 4, wherein a doping concentration of the third gallium nitride layer is greater than a doping concentration of the second gallium nitride layer, and the doping concentration of the third gallium nitride layer is greater than a doping concentration of the first gallium nitride layer.

7. The gallium nitride semiconductor device according to any one of claims 1-6, wherein
a material of the first dielectric layer comprises aluminum nitride; and/or
a thickness of the first dielectric layer ranges from 1nm to 2nm; and/or
a thickness of the first gallium nitride layer ranges from 10nm to 30nm.

8. The gallium nitride semiconductor device according to any one of claims 1-6, further comprising:
an isolation layer, which is disposed in the substrate and divides the substrate into a first portion and a second portion, wherein the first gallium nitride layer is located on the first portion of the substrate;
a fourth gallium nitride layer, which is disposed on the second portion of the substrate;
a second dielectric layer, which is disposed on the fourth gallium nitride layer;
a fifth gallium nitride layer, which is disposed on the second dielectric layer;
a second gate, which is disposed on the fifth gallium nitride layer; and
a second source and a second drain, which are disposed on the second portion of the substrate and are respectively located at two sides of the fourth gallium nitride layer.

9. The gallium nitride semiconductor device according to claim 8, wherein the substrate comprises a semiconductor layer, a nucleation layer, a buffer layer, a channel layer, and a barrier layer stacked in sequence; and the isolation layer is disposed in the buffer layer, the channel layer, and the barrier layer.

10. A method for manufacturing a gallium nitride semiconductor device, **characterized by** comprising:
obtaining a substrate;
forming a first gallium nitride layer on the substrate;
forming a first dielectric layer on the first gallium nitride layer; and
forming a first gate on the first dielectric layer.

11. The method for manufacturing the gallium nitride semiconductor device according to claim 10, wherein the step of forming the first dielectric layer on the first gallium nitride layer comprises:
sequentially forming the first dielectric layer and a second gallium nitride layer on the first gallium nitride layer, wherein the first dielectric layer is located between the first gallium nitride layer and the second gallium nitride layer.

12. The method for manufacturing the gallium nitride semiconductor device according to claim 10, wherein after the step of forming the first dielectric layer on the first gallium nitride layer and before the step of forming the first gate on the first dielectric layer, the method further comprises:
forming a third gallium nitride layer on the first gallium nitride layer, wherein the third gallium nitride layer is located at two sides of the first dielectric layer.

13. The method for manufacturing the gallium nitride semiconductor device according to claim 11, wherein the step of forming the first gate on the first dielectric layer comprises:
forming a groove in the second gallium nitride layer, wherein the groove penetrates through the second gallium nitride layer;
forming a first gate dielectric layer in the groove, wherein the first gate dielectric layer covers at least a bottom of the groove and sidewalls of the groove; and
forming a first gate electrode layer on the first gate dielectric layer.

14. The method for manufacturing the gallium nitride semiconductor device according to claim 12, wherein the step of forming the first gallium nitride layer on the substrate comprises:
forming the first gallium nitride layer on a first portion of the substrate; and
forming a fourth gallium nitride layer, a second dielectric layer and a fifth gallium nitride layer stacked on a second portion of the substrate.

15. The method for manufacturing the gallium nitride semiconductor device according to claim 14, wherein after the step of forming the third gallium nitride layer on the first gallium nitride layer and before the step of forming the first gate on the first dielectric layer, the method further comprises:
forming a first source, a first drain, a second source and a second drain on the substrate, wherein the first source and the first drain are respectively located on the third gallium nitride layer at two sides of the first dielectric layer, and the second source and the second drain are respectively located on the second portion at two sides of the fourth gallium nitride layer.
